(19) Europäisches Patentamt
European Patent Office
Office européen des brevets

(11) Publication number: **0 197 616 B1**

(12) # EUROPEAN PATENT SPECIFICATION

(45) Date of publication of patent specification: **12.08.92**

(51) Int. Cl.5: **C08F 2/50**

(21) Application number: **86200593.1**

(22) Date of filing: **08.04.86**

The file contains technical information submitted after the application was filed and not included in this specification

(54) **Photopolymerizable composition and a photo-initiator system.**

(30) Priority: **09.04.85 NL 8501022**

(43) Date of publication of application:
**15.10.86 Bulletin 86/42**

(45) Publication of the grant of the patent:
**12.08.92 Bulletin 92/33**

(84) Designated Contracting States:
**BE DE FR GB IT NL SE**

(56) References cited:
**US-A- 3 715 293**
**US-A- 3 933 682**
**US-A- 4 071 424**
**US-A- 4 131 529**

(73) Proprietor: **DSM RESINS BV**
**Ceintuurbaan 5**
**NL-8022 AW Zwolle(NL)**

(72) Inventor: **de Koning, Adrianus Johannes**
**Nunspeethoeve 26**
**NL-3137 SH Vlaardingen(NL)**

(74) Representative: **Hoogstraten, Willem Cornelis Roeland et al**
**OCTROOIBUREAU DSM Postbus 9**
**NL-6160 MA Geleen(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

## Description

The invention relates to a photopolymerizable composition comprising one or more polymerizable ethylenically unsaturated compounds and a suitable photo-initiator system.

Under the influence of radiation energy - both ultraviolet and visible light - it is possible to induce the polymerization of ethylenically unsaturated radically polymerizable monomers or oligomers. To this end as a rule photo-initiators are used which are converted to a chemically reactive excited state either by direct light absorption or by the transfer of energy of a photochemically excited sensitizer. The photo-initiators used in actual practice for initiating radical polymerizations can be divided into two main groups:

I photo-initiators generating initiator radicals via intramolecular cleavage (photofragmentation), such as benzoin ethers (DE-A 1694149), benzil ketals (US 3715293) and acylphosphine oxides (EP-A 7086),

II photo-initiators producing initiator radicals via intermolecular hydrogen abstraction; in these redox systems the presence of a hydrogen donor as co-initiator is required.

For the photopolymerization to be efficient it is necessary for the absorption band of the photo-initiator or photosensitizer to properly correspond with the main emission band of the source of radiation applied.

It has been tried to find an efficient photo-initiator system for curing (reinforced) polyester layers having a thickness of 3 to 25 mm. The technical-grade photo-initiators that are used have been found unsuitable for this purpose.

The benzoin ethers and related compounds are active only in the UV region of the spectrum. Using this light it is impossible to cure substrates thicker than about 3 mm owing to the strong absorption of the UV radiation by both the resin and the glass fibre reinforcement that may be present.

Moreover, the disadvantage of UV light is that it is harmful to the eyes and to the skin so that, for the protection of the processors' health, extra safety precautions must be taken.

Under normal circumstances visible light does not have any harmful effects on health. Using the photo-initiators active in the spectral range between 400 and 500 nm, for instance redox systems, as described in the Netherlands patent 165570, it is possible theoretically to cure thick reinforced substrates. In actual practice, however, it has been found that these photo-initiators are not suitable for curing thick reinforced substrates by means of visible light.

According to the said Netherlands patent 165570 (corresponding with US 4071424) the photopolymerizable composition comprises a photo-initiator system containing

(a) a compound having the formula

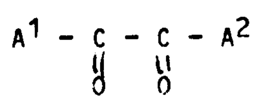

where the groups $A^1$ and $A^2$, which may be the same or different, represent an aromatic hydrocarbon group or substituted aromatic hydrocarbon group and the groups $A^1$, $A^2$ may further be linked together by a direct link or by a divalent hydrocarbon group, or may together form a fused aromatic ring system, and (b) as reducing agent capable of reducing the photo-initiator when it is in an excited state one or more compounds having the formula

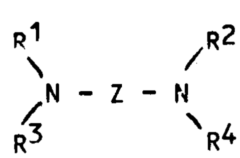

where the groups $R^1$-$R^4$, which are the same or different, are hydrogen atoms or hydrocarbon groups, and Z is an alkylene group or substituted alkylene group with at least two carbon atoms.

The composition according to the invention provides an improvement of such a composition and is characterized in that (a) is applied in 0.001-1 % (wt) with respect to the ethylenically unsaturated compounds and in that the photoinitiator system contains (c) 0.001-1 % (wt) with respect to the ethylenically unsaturated compounds of a monoketal of 1,2 diketone, having the formula

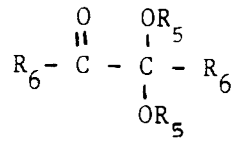

where $R_5$ = alkyl; aryl
$R_6$ = hydrogen; (substituted) alkylgroup, aryl group or cycloalkylgroup.

One or more of groups $R_1$, $R_2$, $R_3$ and $R_4$ may be represented by an alkyl group.

In US-A-3.715.293 the application of a monoketal of a 1,2-diketone as a photo-initiator for curing resins is described, but it is only applied in thin layers and the resins are only cured by UV-light.

The invention further relates to a process for curing a layer of a photopolymerizable composition comprising an ethylenically unsaturated resin whereby the curing is achieved by radiation of visible light on the layer, which has a thickness of 3-25 mm, and wherein said composition further comprises a photo-initiator system containing as photo-initiator 0.001-1 % (wt) with respect to the resin compound of a compound having the formula

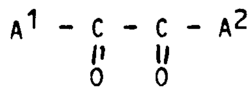

where the groups $A^1$, $A^2$, which may be the same or different, represent an aromatic hydrocarbon group or substituted hydrocarbon group and the groups $A^1$, $A^2$ may further be linked together by a direct link or by a divalent hydrocarbon group, or may together form a fused aromatic ring system and (b) as reducing agent capable of reducing the photo-initiator when it is in an excited state one or more compounds having the formula

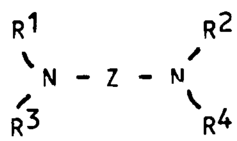

where the groups $R^1$-$R^4$, which are the same or different, are hydrogen atoms or hydrocarbon groups, and Z is an alkylene or substituted alkylene group with at least two carbon atoms, and 0.001-1 % (wt) of a monoketal of 1,2 diketone having the formula

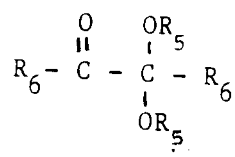

where $R_5$ = alkyl; aryl
$R_6$ = hydrogen; (substituted) alkylgroup, aryl group or cycloalkylgroup is added to the photo-initiator system.

Examples of diamines are ethylene diamine, trimethylene diamine, tetramethylene diamine, pentamethylene diamine, hexamethylene diamine or N-hydrocarbon, such as N-alkyl derivatives thereof. The concentration of these reducing agents in the photo-sensitive composition is preferably between 0.001 and 10 % (wt) calculated on the polymerizable ethylenically unsaturated compound.

The monoketals of 1,2 diketones constitue a class of photo-initiators which, unlike the structurally related benzoin ethers, do not have any adverse effect on the keeping qualities of ethylenically unsaturated compounds.

Examples are monoketals of benzil, 2,2'-dichlorobenzil and 4,4-dichlorobenzil, and monoketals of benzil with aliphatic diols with 2 to 8 carbon atoms, such as ethylene glycol, 1,2 propylene glycol, 1,3-propylene glycol, 1,2-butylene glycol, 1,3 butylene glycol, 2,3 butylene glycol, neopentyl glycol (2,2-dimethyl-propylene glycol-1,3).

According to a preferred embodiment of the invention the diamine is tetramethylethylene diamine or tetramethyl-1,6-hexane diamine.

According to another preferred embodiment of the invention the monoketal of 1,2 diketone is benzildimethylketal. According to yet another preferred embodiment the photo-initiator applied having the formula

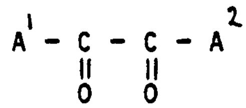

is benzil or 4,4'-dimethylbenzil, the reducing agent tetramethylethylene diamine or tetramethyl-1,6-hexane diamine and the monoketal of 1,2-diketone benzildimethylketal.

The molar ratio of the photo-initiator having the formula

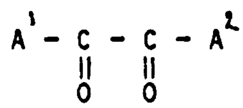

to the monoketal of 1,2 diketone and particularly to benzildimethylketal is preferably between 5 : 1 and 1 : 5, most preferably about 1 : 1.

According to a further preferred embodiment of the invention 0.001-1 % (wt) of a polyhalogen-containing compound is added to the photo-initiator system. The polyhalogen-containing compound is an aliphatic compound having at least one carbon atom with two or more halogen atoms, a cycloaliphatic compound having at least one carbon atom - forming part of the ring system - with two halogen atoms, an aromatic compound having at least two carbon atoms with one halogen atom and/or a halogenalkyl-cycloaliphatic and/or halogenalkyl-aromatic compound in which at least one carbon atom of the alkyl portion contains two or more halogen atoms.

According to a further preferred embodiment of the invention the polyhalogen-containing compound applied is carbon tetrachloride, hexachloroethane, heptachloropropane, octachloropropane, heptachlorocyclohexane or hexachlorobenzene.

The photo-initiators with the formula

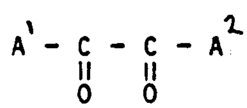

that can be used are notably benzil compounds, in which the two groups A are phenyl, α-naphthyl and β-naphthyl, i.e. α-diketones in which the two groups A are fused aromatic groups, and p-tolyl an α-diketone, in which the groups A are arylalkyl groups, a furyl, for instance 2,2'-furyl, phenanthrenequinone, an α-diketone in which A represents a phenyl group and the two groups A are linked by a direct link ortho in respect of the keto groups, acenaphthaquinone and an α-diketone in which the groups A are substituted by non-hydrocarbon groups, for instance p,p'-dimethoxybenzyl, p,p'-dichlorobenzyl and p-nitrobenzyl.

These photo-initiators are used in amounts between 0,001 and 1 % (wt).

Preference is given to the combination in which the photo-initiator used is benzil or 4,4'-dimethylbenzil, the reducing agent tetramethylethylene diamine or tetramethyl-1,6-hexane diamine, the monoketal of 1,2 diketone benzildimethylketal and the polyhalogen-containing compound carbon tetrachloride or heptachloropropane.

The ethylenically unsaturated compound is preferably an unsaturated polyester. This unsaturated polyester is generally composed of one or more aliphatic and/or cycloaliphatic monovalent, divalent and/or polyvalent alcohols and one or more aliphatic, cycloaliphatic and/or aromatic divalent or polyvalent carboxylic acids and, if so desired, monocarboxylic acids and/or esters derived therefrom. Examples of suitable alcohols are benzyl alcohol, ethylene glycol, propylene glycol, neopentyl glycol, hexane diol, dimethylcyclohexane, diethylene glycol, glycerol, trimethylolpropane, pentaerythritol and/or dipentaerythritol. Instead of or in addition to the alcohol compound(s) one or more epoxy compounds can be used, such as for instance ethylene oxide, propylene oxide and/or allylglycidyl ether. Examples of suitable divalent or

polyvalent carboxylic acids are maleic acid, fumaric acid, itaconic acid, citraconic acid, malonic acid, succinic acid, glutaric acid, adipic acid, sebacic acid, tetrahydrophthalic acid, hexahydrophthalic acid, hexachloroendomethylene tetrahydrophthalic acid, dichlorophthalic acid, isophthalic acid, terephthalic acid and/or trimellitic acid. The carboxylic acid can be used also in the form of an anhydride, for instance maleic anhydride or phthalic anhydride.

The dicarboxylic acid component used is preferably the maleic anhydride, often in combination with isophthalic acid and/or orthophthalic acid. If so desired, the unsaturated polyester may also contain saturated or unsaturated monocarboxylic acids, such as synthetic and/or natural fatty acids with 2 to 36 carbon atoms or esters prepared from these carboxylic acids and polyvalent alcohols, such as glycerol. Examples of suitable monocarboxylic acids are lauric acid, stearic acid, oleic acid, linoleic acid, benzoic acid, acrylic acid and/or methacrylic acid.

The polyester can be prepared in various ways, for instance by means of the melting process in which the reaction of the components and the evaporation of the water released in the reaction coincide. However, it is possible also to apply a solvent process with azeotropic removal of the water.

Other ethylenically unsaturated ester resins that can be used according to the process according to the invention are the so-called vinyl esters. These Vinyl esters can be prepared by a reaction of an epoxy resin with an unsaturated carboxylic acid. Examples of such vinyl esters are the reaction products of 2 moles $\alpha,\beta$ ethylenically unsaturated acid, such as methacrylic acid or acrylic acid, with 1 mole of an epoxy polymer, such as the diglycidyl ether of 2,2-di(4-hydroxy-phenyl)propane and the diglycidyl ether of phenolformaldehyde resins.

Examples of suitable ethylenically unsaturated monomers serving as reactive solvent for the unsaturated polyester and vinyl esters are styrene, $\alpha$-methylstyrene, p-methylstyrene, vinyl toluene, divinyl benzene, dialyl phthalate and acrylic acid or methacrylic acid (hydroxy)esters of alcohols with 1 to 12 carbon atoms, such as methanol, ethanol, propanol, butanol, ethylene glycol, propylene glycol, neopentyl glycol, butanediol, hexanediol, polyethylene glycol, glycerol, trimethylolethane, trimethylolpropane and pentaerythritol. Preference is given to the use of styrene. Suitable also are mixtures of monomers, particularly of styrene and other monomers.
The monomeric compound is usually present in the resin in an amount of 2 to 55 % calculated on the total amount.

The photopolymerizable resins can be stabilized with the customary inhibitors. Examples of such compounds are phenolic inhibitors such as (substituted) hydroquinone, benzoquinone, chloranil and nitrobenzene.

Certain UV stabilizers, too, can be added to the resin without having any effect on the photochemically induced curing, which takes place, after all, under the influence of visible light. Examples of such compounds are the oxybenzophenone, salicylic acid esters and oxyphenylbenztriazoles.

The thickener for polyester resins may be oxides and hydroxides of, for instance, lithium, magnesium, calcium or zinc, or metal alcoholates of, for instance, magnesium, calcium, aluminium or titanium.

Fillers like aluminium trihydrate, quartz sand, glass powder, barium sulphate and lime can also be added to the resins. The powdery fillers, however, must be transparent to the light used for the photochemical curing (370-450 nm) so that in thick layers, too, the polymerization proceeds well.

As reinforcing materials for unsaturated polyester and vinyl ester resins both inorganic and organic fibres are eligible. Examples of such materials are glass fibres, carbon fibres, polyesters and aromatic polyamides.

Lubricants such as metal stearates and polyethylene waxes can be also added to polyester resins.

Finally, mention is made of the low profile additives. A few examples of these shrink-resistant additives are, for instance, polystyrene, polyvinylacetate and polymethacrylate.

In addition to the photo-initiator system according to the invention, thermally decomposing radical initiators, too, may be added in amounts of 0.01 to 2.0 % (wt). The curing of the shaped polyester article is usually promoted by these, but the pot life of the polyester resin, of course, will show a strong decrease. Examples of thermally decomposing initiators known in the art are peresters, such as tert-butylperoctoate and tert-butylperpivalate; percarbonates, such as bis-4-tert-butylcyclohexylperoxidicarbonate, diacyl peroxides, such as benzoyl peroxide; dialkyl peroxides, such as di-tert. butylperoxides and dicumylperoxide; azo compounds, such as azodiisobutyronitrile; C-C unstable compounds, such as tetra-substituted dibenzyl compounds.

The photopolymerizable compositions according to the invention can be used during the processing of resin such as, for instance, lamination for the production of big articles, filament winding for the production of, for instance, tubes, pulltrusion and discontinuous moulding techniques.

The invention is further elucidated by means of the examples following hereinafter without, however,

being limited thereto.

Examples 1 and 2 and comparative examples 1 and 2

In order to determine the activity of the light radiation curing system the temperature variation in the resin is observed during the irradiation. To this end a thermocouple connected to a recorder is placed in a glass cylinder with a diameter of 3 cm filled with 10 g polyester resin (thickness of resin layer 10 mm). In order to preclude loss of heat the resin-filled glass vessel is surrounded with polyurethane foam for the duration of the irradiation.

The source of radiation applied consists of a series of 5 40-watt fluorescent tubes in parallel having a wavelength maximum of 420 nm; the relative distances between the tubes are 10 cm. The distance from the tube system to the surface of the substrate is in all cases 20 cm.

The quantities that are measured are:

a. the maximum temperature acquired by the resin during the irradiation ($T_{max}$)

b. the time that passes from the beginning of the irradiation till the moment when the top temperature is reached ($t_{max}$)

c. the Barcol hardness (GYZJ 934-1) on top as well as on the bottom of the cured article 3 hours after the irradiation was stopped. The irradiation is discontinued 5 minutes after reaching the maximum temperature.

Every experiment was made at least three times. At the beginning the temperature of the resin is in all cases 25 ¤C.

An average-reactive isophthalic acid polyester resin consisting of 39 % (wt) styrene and 61 % (wt) unsaturated polyester has been used. The acid number of the resin is 11-15 mg KOH/g.

In these examples the efficiency of a few photo-initiators of the redox type are tested in the absence (comparative examples 1 and 2) and in the presence (examples 1 and 2) of benzildimethylketal. To the polyester resin 0.3 % (wt) benzil and 1.0 % (wt) reducing agent are added. Further in examples 1 and 2, 0.2 % (wt) benzildimethylketal is added. The results of these experiments are mentioned in the table below.

| | Reducing agent | t max (min) | T max ¤C | Barcol hardness above | Barcol hardness below |
|---|---|---|---|---|---|
| Comp. ex. 1 | N,N,N',N'-tetramethyl-ethylene diamine | 10 | 142 | 33 | 32 |
| Comp. ex. 2 | N,N,N',N'-tetramethyl-1,6-hexane diamine | 13 | 142 | 33 | 31 |
| example 1 | N,N,N',N'-tetramethyl-ethylene diamine | 10 | 144 | 35 | 36 |
| example 2 | N,N,N',N'-tetramethyl 1,6-hexane diamine | 13 | 145 | 35 | 36 |

The systems according to the comparative examples are unsuitable for efficiently curing thick polyester layers (0.3-2.5 cm). The Barcol hardness on the underside of the irradiated article is insufficient.

The curing of the samples containing aliphatic diamine according to the invention has shown a real improvement, owing to the addition of the benzildimethylketal, unlike the addition of benzildimethylketal to samples containing reducing agents as described in the examples of the Netherlands patent 165570 (notably N,N-dimethylaminoethylmethacrylate). This improved curing-in-depth is important notably for curing

thick layers (0.3 to 2.5 cm) of glass-fibre-reinforced polyester moulded articles.

Example 3

Rectangular laminates having a surface area of 375 $cm^2$ have been made on the basis of the previously described polyester resin and glass mats (chopped strand mat, 450 $g/m^2$). The glass content of the laminates was about 33 % (wt). Layers with thicknesses of 5, 10 and 20 mm have been cured. The source of radiation is again the set of five 40-Watt fluorescent tubes placed in parallel with a wavelength maximum of 420 mm. The distance between the laminate and the tubes is 20 cm. The substrate for the laminate is a wooden plate with a thickness of 1 cm.

The photo-initiator system used is benzil (0.3 % (wt) calculated on the polyeter resin), N,N,N',N'-tetramethylethylene diamine (1 % (wt)) and benzildimethylketal (0.2 % (wt)).

| Laminate thickness (mm) | $t_{max}$ (min) | $T_{max}$ (¤C) | period of irra-diation (min) | Barcol hardness above | below |
|---|---|---|---|---|---|
| 5 | 10 | 85 | 15 | 37 | 44 |
| 10 | 13 | 115 | 20 | 41 | 46 |
| 20 | 21 | 105 | 60 | 42 | 45 |

This example shows that, with the said photo-initiator system thick glass fibre-reinforced polyester layers can be cured efficiently.

**Claims**

**1.** Photopolymerizable composition comprising one or more polymerizable ethylenically unsaturated compounds and a photo-initiator system containing (a) a compound having the formula

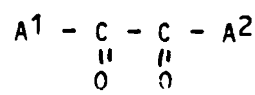

where the groups $A^1$ and $A^2$, which may be the same or different, represent an aromatic hydrocarbon group or substituted aromatic hydrocarbon group and the groups $A^1$, $A^2$ may further be linked together by a direct link or by a divalent hydrocarbon group, or may together form a fused aromatic ring system, and (b) as reducing agent capable of reducing the photo-initiator when it is in an excited state one or more compounds having the formula

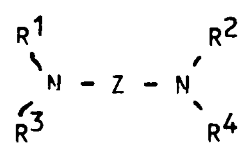

where the groups $R^1$-$R^4$, which are the same or different, are hydrogen atoms or hydrocarbon groups, and Z is an alkylene group or substituted alkylene group with at least two carbon atoms, characterized in that (a) is applied in 0.001-1 % (wt) with respect to the ethylenically unsaturated compounds and in that the photoinitiator system contains (c) 0.001-1 % (wt) with respect to the ethylenically unsaturated compounds of a monoketal of 1,2 diketone having the formula

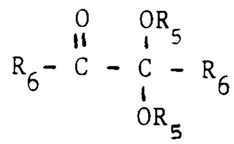

where $R_5$ = alkyl; aryl
$R_6$ = hydrogen; (substituted) alkylgroup, aryl group or cycloalkylgroup.

2. Photopolymerizable composition according to claim 1, characterized in that the diamine used is tetramethylethylene diamine or tetramethyl-1,6-hexanediamine.

3. Photopolymerizable composition according to any one of claims 1-2, characterized in that the monoketal of 1,2 diketone used is benzildimethylketal.

4. Photopolymerizable composition according to any one of claims 1-3, characterized in that the photoinitiator used having the formula

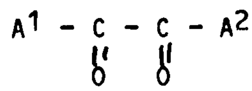

is benzil or 4,4'-dimethylbenzil.

5. Photopolymerizable composition according to any one of claims 1-4, characterized in that the molar ratio of the photo-initiator having the formula

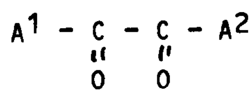

to the monoketal of 1,2 diketone is from 5 : 1 to 1 : 5.

6. Photopolymerizable composition according to claim 5, characterized in that the molar ratio of the photoinitiator having the formula

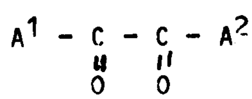

to the monoketal of 1,2 diketone is about 1 : 1.

7. Photopolymerizable composition according to any one of claims 1-6, characterized in that 0.001-1 % (wt) of a polyhalogen-containing compound is added to the photo-initiator system.

8. Photopolymerizable composition according to claim 7, characterized in that the polyhalogen-containing compound applied is carbon tetrachloride, hexachloroethane, heptachloropropane, octachloropropane, heptachlorocyclohexane or hexachlorobenzene.

9. Photopolymerizable composition according to any one of claims 1-8, characterized in that the polymerisable ethylenically unsaturated compound is an unsaturated polyester or vinyl ester resin.

10. Photopolymerizable composition according to claim 9, characterized in that the polymerisable unsaturated compound is an unsaturated polyester resin.

**11.** Process for curing a layer of a photopolymerizably composition comprising an ethylenically unsaturated resin, characterized in that the curing is achieved by radiation of visible light on the layer, which has a thickness of 3-25 mm, and wherein said composition further comprises a photo-initiator system containing as photo-initiator 0.001-1 % (wt) with respect to the resin compound having the formula

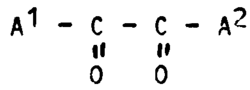

where the groups $A^1$, $A^2$, which may be the same or different, represent an aromatic hydrocarbon group or substituted aromatic hydrocarbon group and the groups $A^1$, $A^2$ may further be linked together by a direct link or by a divalent hydrocarbon group, or may together form a fused aromatic ring system and (b) as reducing agent capable of reducing the photo-initiator when it is in an excited state one or more compounds having the formula

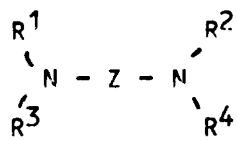

where the groups $R^1$-$R^4$, which are the same or different, are hydrogen atoms or hydrocarbon groups, and Z is an alkylene or substituted alkylene group with at least two carbon atoms, and 0.001-1 % (wt) of a monoketal of 1,2 diketone having the formula

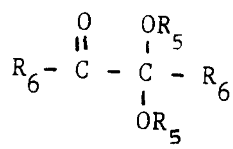

where $R_5$ = alkyl; aryl
$R_6$ = hydrogen; (substituted) alkylgroup, aryl group or cycloalkylgroup
is added to the photo-initiator system.

**12.** Process according to claim 11, characterized in that 0.001-1 % (wt) with respect to the resin of a polyhalogen-containing compound is added to the photo-initiator system.

**Revendications**

**1.** Composition photopolymérisable comprenant un ou plusieurs composé(s) polymérisable(s) à insaturation éthylénique et un système photo-activant contenant (a) on composé de formule :

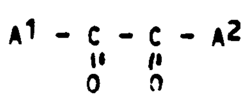

dans laquelle les groupes $A^1$ et $A^2$, qui peuvent être identiques ou différents, représentent chacun un radical hydrocarboné aromatique ou un radical hydrocarboné aromatique substitué et les groupes $A^1$ et $A^2$ peuvent être en outre unis par une liaison directe ou par un radical hydrocarboné divalent, ou bien ils peuvent former conjointement un système de noyau aromatique condensé, et (b), à titre d'agent réducteur capable de réduire le photo-activant, quand il est dans un état excité un ou plusieurs composé(s) de formule :

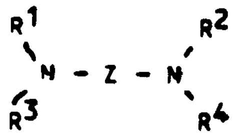

dans laquelle les radicaux $R^1$ à $R^4$, qui peuvent être identiques ou différents, représentent chacun un atome d'hydrogène ou un radical hydrocarboné et Z est un radical alkylène ou un radical alkylène substitué contenant au moins 2 atomes de carbone, caractérisée en ce que (a) est appliqué à raison de 0,001-1% en poids par rapport aux composés à insaturation éthylénique et en ce que le système photoactivant contient (c) de 0,001 à 1% en poids par rapport aux composés à insaturation éthylénique d'un monocétal de 1,2-dicétone de formule :

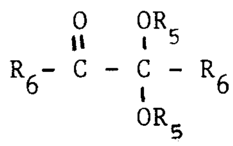

dans laquelle $R_5$ est un radical alkyle ou aryle, et $R_6$ est un atome d'hydrogène, un radical alkyle (substitué), un radical aryle ou cycloalkyle.

**2.** Composition photopolymérisable selon la revendication 1, caractérisée en ce que la diamine utilisée est la tetraméthyléthylènediamine ou la tetraméthyl-1,6-hexane-diamine.

**3.** Composition photopolymérisable selon la revendication 1 ou 2, caractérisée en ce que le monocétal de 1,2-dicétone utilisé est le benzildiméthylcétal.

**4.** Composition photopolymérisable selon l'une quelconque des revendications 1 à 3, caractérisé en ce que le photo-activant de formule :

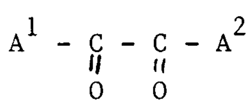

est le benzile ou le 4,4'-diméthylbenzile.

**5.** Composition photopolymérisable selon l'une quelconque ds revendications 1 à 4, caractérisée en ce que le rapport molaire du photo-activant de formule :

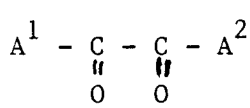

au monocétal de 1,2-dicétone est compris entre 5:1 et 1:5.

**6.** Composition photopolymérisable selon la revendication 5, caractérisée en ce que le rapport molaire du photo-activant de formule :

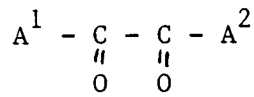

au monocétal de 1,2-dicétone est d'environ 1:1.

7. Composition photopolymérisable selon l'une quelconque des revendications 1 à 6, caractérisée en ce qu'on ajoute au système photo-activant une proportion de 0,001 à 1% en poids d'un composé polyhalogéné.

8. Composition photopolymérisable selon la revendication 7, caractérisée en ce que le composé polyhalogéné utilisé est le tetrachlorure de carbone, l'hexachloréthane, l'heptachloropropane, l'octachloropropane, l'heptachlorocyclohexane ou l'hexachlorobenzène.

9. Composition photopolymérisable selon l'une quelconque des revendications 1 à 6, caractérisée en ce que le composé polymérisable à insaturation éthylénique est un polyester insaturé ou une résine d'ester vinylique.

10. Composition photopolymérisable selon la revendication 9, caractérisée en ce que le composé polymérisable insaturé est une résine insaturée de polyester.

11. Procédé de durcissement d'une couche d'une composition photopolymérisable comprenant une résine à insaturation éthylénique, caractérisé en ce qu'on réalise le le durcissement par rayonnement de lumière visible sur la couche, dont l'épaisseur est de 3 à 25 mm et dans lequel ladite composition comprend en outre un système photo-activant contenant, à titre de photo-activant, 0,001 à 1% en poids par rapport à la résine, d'un composé de formule :

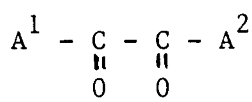

dans laquelle les groupes $A^1$, $A^2$, qui peuvent être identiques ou différents, représentent chacun un radical hydrocarboné aromatique ou un radical hydrocarboné aromatique substitué et les groupes $A^1$ et $A^2$ peuvent, en outre, être liés ensemble par une liaison directe ou par un groupe hydrocarboné divalent, ou peuvent former conjointement un noyau aromatique condensé et (b) à titre d'agent réducteur capable de réduire le photo-activant quand il est dans un état excité, un (ou plusieurs) composé de formule :

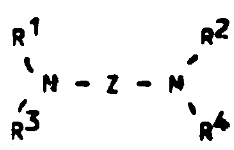

dans laquelle les groupes $R^1$ à $R^4$, qui peuvent être identiques ou différents, représentent chacun un atome d'hydrogène ou un radical hydrocarboné, et Z est un radical alkylène ou alkylène substitué avec au moins deux atomes de carbone, et 0,001 à 1% en poids d'un monocétal de 1,2 dicétone de formule :

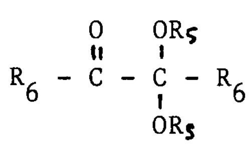

dans laquelle $R_5$ est un radical alkyle ou aryle et $R_6$ est un atome d'hydrogène, un radical alkyle (substitué), un radical aryle ou cycloalkyle, est ajouté au système photoactivant.

**12.** Procédé selon la revendication 11, caractérisé en ce qu'on ajoute au système photo-activant de 0,001 à 1% en poids par rapport à la résine d'un composé polyhalogéné.

**Patentansprüche**

**1.** Photopolymerisierbare Zusammensetzung umfassend eine oder mehrere polymerisierbare äthylenisch ungesättigte Verbindungen und ein Photoinitiatorsystem enthaltend (a) eine Verbindung der Formel

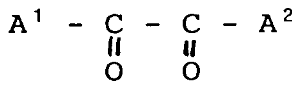 ,

worin die Gruppen $A^1$ und $A^2$, die gleich oder verschieden sein können, eine aromatische Kohlenwasserstoffgruppe oder eine substituierte aromatische Kohlenwasserstoffgruppe bedeuten und die Gruppen $A^1$ und $A^2$ weiter durch eine Direktbindung oder durch eine zweiwertige Kohlenwasserstoffgruppe miteinander verbunden sein können oder miteinander ein kondensiertes aromatisches Ringsystem bilden können, und (b) als Reduktionsmittel, das zum Reduzieren des Photoinitiators imstande ist, wenn er in einem angeregten Zustand ist, eine oder mehrere Verbindungen der Formel

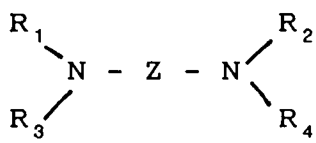 ,

worin die Gruppen $R_1$ bis $R_4$, die gleich oder verschieden sind, Wasserstoffatome oder Kohlenwasserstoffgruppen sind und Z eine Alkylengruppe oder eine substituierte Alkylengruppe mit mindestens zwei Kohlenstoffatomen bedeutet, dadurch gekennzeichnet, daß (a) in einer Menge von 0,001 bis 1 Gew.%, bezogen auf die äthylenisch ungesättigten Verbindungen, verwendet wird und daß das Photoinitiatorsystem (c) 0,001 bis 1 Gew., bezogen auf die äthylenisch ungesättigten Verbindungen, eines Monoketals von 1,2-Diketon der Formel

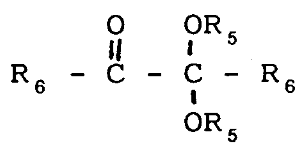 ,

worin $R_5$ Alkyl oder Aryl bedeutet und $R_6$ Wasserstoff oder eine (substituierte) Alkyl-, Aryl- oder Cycloalkylgruppe darstellt, enthält.

**2.** Photopolymerisierbare Zusammensetzung nach Anspruch 1, dadurch gekennzeichnet, daß das verwendete Diamin Tetramethyläthylendiamin oder Tetramethyl-1,6-hexandiamin ist.

**3.** Photopolymerisierbare Zusammensetzung nach einem der Ansprüche 1 bis 2, dadurch gekennzeichnet, daß das verwendete Monoketal von 1,2-Diketon Benzildimethylketal ist.

**4.** Photopolymerisierbare Zusammensetzung nach einem der Ansprüche 1 bis 3, dadurch gekennzeichnet, daß der verwendete Photoinitiator der Formel

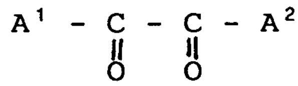

Benzil oder 4,4'-Dimethylbenzil ist.

5. Photopolymerisierbare Zusammensetzung nach einem der Ansprüche 1 bis 4, dadurch gekennzeichnet, daß das Molverhältnis des Photoinitiators der Formel

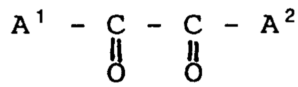

zum Monoketal von 1,2-Diketon 5 : 1 bis 1 : 5 beträgt.

6. Photopolymerisierbare Zusammensetzung nach Anspruch 5, dadurch gekennzeichnet, daß das Molverhältnis des Photoinitiators der Formel

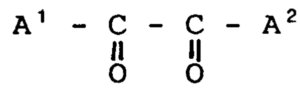

zum Monoketal von 1,2-Diketon etwa 1 : 1 beträgt.

7. Photopolymerisierbare Zusammensetzung nach einem der Ansprüche 1 bis 6, dadurch gekennzeichnet, daß dem Photoinitiatorsystem 0,001 bis 1 Gew.% einer polyhalogenhaltigen Verbindung zugesetzt ist.

8. Photopolymerisierbare Zusammensetzung nach Anspruch 7, dadurch gekennzeichnet, daß die verwendete polyhalogenhaltige Verbindung Tetrachlorkohlenstoff, Hexachloräthan, Heptachlorpropan, Octachlorpropan, Heptachlorcyclohexan oder Hexachlorbenzol ist.

9. Photopolymerisierbare Zusammensetzung nach einem der Ansprüche 1 bis 8, dadurch gekennzeichnet, daß die polymerisierbare äthylenisch ungesättigte Verbindung ein ungesättigtes Polyester- oder Vinylesterharz ist.

10. Photopolymerisierbare Zusammensetzung nach Anspruch 9, dadurch gekennzeichnet, daß die polymerisierbare ungesättigte Verbindung ein ungesättigtes Polyesterharz ist.

11. Verfahren zum Härten einer Schicht einer photopolymerisierbaren Zusammensetzung umfassend ein äthylenisch ungesättigtes Harz, dadurch gekennzeichnet, daß das Härten durch Strahlung von sichtbarem Licht auf die Schicht erzielt wird, die eine Dicke von 3 bis 25 mm hat, und wobei die Zusammensetzung weiter ein Photoinitiatorsystem aufweist, das als Photoinitiator 0,001 bis 1 Gew., bezogen auf die Harzverbindung, einer Verbindung der Formel

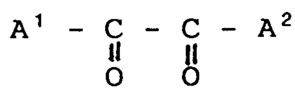 ,

worin die Gruppen $A^1$ und $A^2$, die gleich oder verschieden sein können, eine aromatische Kohlenwasserstoffgruppe oder eine substituierte aromatische Kohlenwasserstoffgruppe bedeuten und die Gruppen $A^1$ und $A^2$ weiter durch eine Direktbindung oder durch eine zweiwertige Kohlenwasserstoffgruppe miteinander verbunden sein können oder miteinander ein kondensiertes aromatisches Ringsystem bilden können, und (b) als Reduktionsmittel, das zum Reduzieren des Photoinitiators imstande ist, wenn er in einem angeregten Zustand ist, eine oder mehrere Verbindungen der Formel

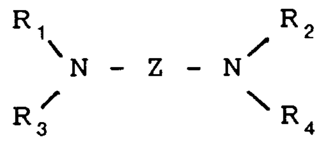

,

worin die Gruppen $R_1$ bis $R_4$, die gleich oder verschieden sind, Wasserstoffatome oder Kohlenwasserstoffgruppen sind und Z eine Alkylengruppe oder eine substituierte Alkylengruppe mit mindestens zwei Kohlenstoffatomen bedeutet, enthält, und 0,001 bis 1 Gew.% eines Monoketals von 1,2-Diketon der Formel

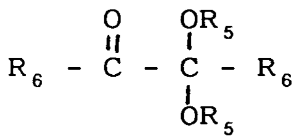

,

worin $R_5$ Alkyl oder Aryl bedeutet und $R_6$ Wasserstoff oder eine (substituierte) Alkyl-, Aryl- oder Cycloalkylgruppe darstellt, dem Photoinitiatorsystem zugesetst wird.

**12.** Verfahren nach Anspruch 11, dadurch gekennzeichnet, daß dem Photoinitiatorsystem 0,001 bis 1 Gew.%, bezogen auf das Harz, einer polyhalogenhaltigen Verbindung zugesetzt wird.